# EUROPEAN PATENT SPECIFICATION

(11) **EP 3 916 295 B1**
(45) Date of publication and mention of the grant of the patent: **18.03.2026**
(21) Application number: 21176395.8
(22) Date of filing: 27.05.2021
(51) Int. Cl.: F21S 43/14, F21S 43/19, F21S 45/48, F21S 45/50, F21W 103/10, F21W 103/20, F21W 103/55

(54) **AUTOMOTIVE LIGHTING DEVICE**
AUTOMOBILBELEUCHTUNGSVORRICHTUNG
DISPOSITIF D'ÉCLAIRAGE D'AUTOMOBILE

(30) Priority: 27.05.2020 FR 2005613
(43) Date of publication of application: 01.12.2021
(73) Proprietor: Valeo Vision, 93012 Bobigny Cedex (FR)
(72) Inventor: CANTUDO FRANCO, Miguel Angel, 93012 BOBIGNY Cedex (FR); ROLDAN ZAFRA, Jose David, 93012 BOBIGNY Cedex (FR)
(74) Representative: Valeo Visibility

(56) References cited:
- EP-A1- 3 073 182
- EP-A1- 3 279 552
- EP-A1- 3 650 745
- CN-A- 109 812 777
- DE-A1- 102017 129 311
- US-A1- 2002 041 498
- US-A1- 2017 254 518
- US-A1- 2020 088 371

## Description

This invention is related to the field of automotive lighting devices, and more particularly, to the temperature management of these devices.

Automotive lighting market can be considered one of the most competitive ones and new lighting functionalities are constantly required.

Current trends try to provide smaller devices, so it is important to detect those elements which are not necessary or the size of which may be reduced in order to obtain a smaller final result. US 2020/088371 A1 shows a compact automotive lighting device.

However, functionality requirements are still present, and features like watertightness, ESD protection and reliability should be ensured despite the improvements in other areas.

It is therefore a challenge to reduce the size of the lighting devices but without compromising the quality. A solution for this problem is therefore sought.

The invention provides an alternative solution for this problem by an automotive lighting device according to appended claim 1.

The term "solid state" refers to light emitted by solid-state electroluminescence, which uses semiconductors to convert electricity into light. Compared to incandescent lighting, solid state lighting creates visible light with reduced heat generation and less energy dissipation. The typically small mass of a solid-state electronic lighting device provides for greater resistance to shock and vibration compared to brittle glass tubes/bulbs and long, thin filament wires. They also eliminate filament evaporation, potentially increasing the lifespan of the illumination device. Some examples of these types of lighting comprise semiconductor light-emitting diodes (LEDs), organic light-emitting diodes (OLED), or polymer light-emitting diodes (PLED) as sources of illumination rather than electrical filaments, plasma or gas

The circuit element may be a printed circuit board or a similar element which performs the function of providing physical support and electrical connections to the light sources.

The sealing element provides the circuit element to act as a watertight cap in the lighting device. This allows a totally new concept in the building of a lighting device, since no additional cap is needed.

When defining "in contact with the hole edge", it means that the seal is providing a watertight closing for the hole of the housing. As the skilled person will construe, to achieve that, it is not necessary that the seal is located in the very edge of the housing hole, in an analogous way that it is not necessary that the seal contacts the side edge of the circuit element. The watertight closing may be achieved with the seal surrounding the hole and this option should also be considered as being within the scope of the present invention.

According to the invention, the first face of the circuit element comprises a copper layer and the at least one solid-state light source is arranged in the copper layer by means of a solder mask.

This way of attaching the solid-state light sources to the copper layer of the first face of the base is also used with the present invention.

According to the invention, the second face of the circuit element comprises a metallic base which is attached to the copper layer by means of a dielectric element.

The metallic base provides a mechanic support for the elements which are attached thereto, since the mechanical stability is important to keep the projected light source in the correct direction.

In some particular embodiments, the metallic base comprises aluminium and/or an aluminium alloy.

These metallic options provide both a good mechanic support and thermal dissipation ability.

According to the invention, the sealing element is arranged in contact with the first face of the circuit element.

This means that the circuit element needs to be bigger than the housing hole, so that the sealing element is located outside the hole and abutting against the housing wall surrounding the hole.

In some particular embodiments out of the scope of this invention, the sealing element is arranged in contact with the side edge of the circuit element.

This means that the side edge of the circuit element is smaller than the housing hole and fits therein. The sealing element is located between the edge of the circuit element and the hole edge of the housing, to provide the watertight closing.

According to the invention, , the heat dissipation element is a radiation layer which has an emissivity higher than 0.5 and more particularly, higher than 0.8.

This lighting device does not need a heavy heat sink, since the radiation layer is in charge of dissipating the heat by radiation, instead of by convection, as traditional heat sinks do. This means saving weight and volume in the lighting device.

In some particular embodiments, the radiation layer is directly deposited on the metallic base.

This direct deposition is useful to avoid any intermediate layers, which may affect to the heat dissipation and add weight and volume to the lighting device.

In some particular embodiments, the radiation layer comprises resin and/or a polyamide, and/or a ceramic compound and/or talc and/or a paint coating.

These are advantageous examples of materials to be used in the lighting device of the invention, due to their emissivity and easiness of use in automotive applications.

In some particular embodiments, the radiation layer is obtained by processing the second face of the circuit element.

This alternative is interesting since it does not involve the use of a different material, but just working on the existing elements.

In some particular embodiments, the process comprises an oxidation, corrosion or anodising of the second face of the circuit element.

All of these processes are aimed to increase the emissivity of the metallic base and then increase the heat dissipation.

In some particular embodiments, the radiation layer has a thickness comprised between 0.5 and 2 mm.

This thickness is enough to convey the heat produced by the light sources.

In some particular embodiments, the solid-state light source is configured to be part of a daytime running light functionality or a turn indicator functionality.

This lighting device is suitable to be used both with daytime running light functionality and turn indicator arrangements, since it does not affect the zones where the light sources are installed.

In some particular embodiments, the automotive lighting device further comprises an optical element suitable for receiving light emitted by the light source and for shaping the light into a light pattern projected outside the lighting device.

An optical element is an element that has some optical properties to receive a light beam and emit it in a certain direction and/or shape, as a person skilled in automotive lighting would construe without any additional burden. Reflectors, collimators, light guides, projection lenses, etc., or the combination thereof are some examples of these optical elements.

Unless otherwise defined, all terms (including technical and scientific terms) used herein are to be interpreted as is customary in the art. It will be further understood that terms in common usage should also be interpreted as is customary in the relevant art and not in an idealised or overly formal sense unless expressly so defined herein.

In this text, the term "comprises" and its derivations (such as "comprising", etc.) should not be understood in an excluding sense, that is, these terms should not be interpreted as excluding the possibility that what is described and defined may include further elements, steps, etc.

To complete the description and in order to provide for a better understanding of the invention, a set of drawings is provided. Said drawings form an integral part of the description and illustrate an embodiment of the invention, which should not be interpreted as restricting the scope of the invention, but just as an example of how the invention can be carried out. The drawings comprise the following figures:

[Fig. 1a] and [Fig. 1b] show a front view and a rear view of some elements of a particular embodiment of an automotive lighting device according to the invention.

[Fig. 2] shows a transverse cut of the circuit board of a particular embodiment of an automotive lighting device according to the invention.

[Fig. 3a] and [Fig. 3b] show a front view and a rear view of a particular embodiment of an automotive lighting device according to the invention.

[Fig. 4] shows an automotive vehicle comprising an automotive lighting device as described in the previous figures.

Elements of the example embodiments are consistently denoted by the same reference numerals throughout the drawings and detailed description where appropriate:

- 1: Printed circuit board
- 2: LED
- 3: Radiation layer
- 4: Sealing joint
- 5: Light guide
- 6: Copper layer
- 7: Solder mask
- 8: Aluminium base
- 10: Automotive lighting device
- 11: First face of the printed circuit board
- 12: Second face of the printed circuit board
- 13: Side edge of the printed circuit board
- 100: Automotive vehicle

The example embodiments are described in sufficient detail to enable those of ordinary skill in the art to embody and implement the systems and processes herein described. It is important to understand that embodiments can be provided in many alternate forms and should not be construed as limited to the examples set forth herein.

Accordingly, while embodiment can be modified in various ways and take on various alternative forms, specific embodiments thereof are shown in the drawings and described in detail below as examples. There is no intent to limit to the particular forms disclosed. On the contrary, all modifications, equivalents, and alternatives falling within the scope of the appended claims should be included. Elements of the example embodiments are consistently denoted by the same reference numerals throughout the drawings and detailed description where appropriate.

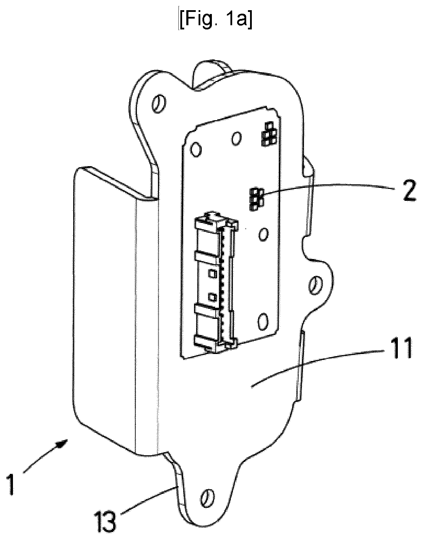

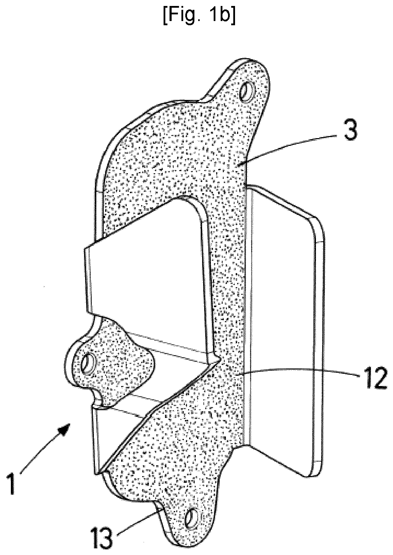

Figures 1a and 1b show a front view and a rear view of some elements of a particular embodiment of an automotive lighting device according to the invention.

Firstly, there is a printed circuit board 1 comprising a first face 11, a second face 12 opposite to the first face 11 and a side edge 13. The first face 11 comprises a copper layer and a plurality of LEDs 2 arranged on the copper layer by means of a solder mask. The second face 12 comprises an aluminium base and a radiation layer 3 which has been directly deposited on it, so only the side 13 of the aluminium base is seen. This radiation layer comprises an emissive paint coating with an emissivity around 0.8 and a thickness of about 1 mm. Other materials are also suitable for this purpose, while their emissivity is higher than 0.5.

In fact, in other embodiments, there is not a deposited layer as such, but is the back surface of the aluminium base which is modified to improve the emissivity on this face of the printed circuit board 1.

The LEDs 2 generate an amount of heat while their normal operation. However, their temperature must stay under control, since an excessive temperature would affect to their operation and may even cause the failure of the LED. There are derating protocols to decrease the current of the LED in the event this temperature overcomes a predetermined threshold.

This heat is transmitted by conduction to the aluminium base and then to the radiation layer 3. The radiation layer 3 dissipates the heat by radiation, without the need of an airflow or an air volume to receive this heat. This contributes to a lighter and smaller lighting device.

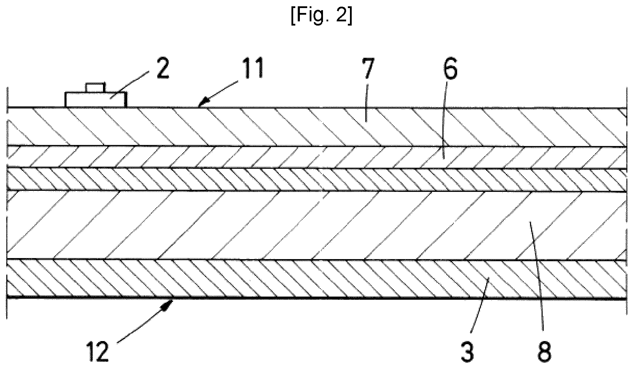

Figure 2 shows a transverse cut of the printed circuit board 1 of a particular embodiment of an automotive lighting device according to the invention.

This lateral view shows the different elements which were presented in the previous figures.

The printed circuit board 1 comprises a first face 11 and a second face 12 opposite to the first face 11. The first face 11 comprises a copper layer 6 and a plurality of LEDs 2 (only one of them is shown in this figure) arranged on the copper layer 6 by means of a solder mask 7.

In turn, the second face 12 comprises an aluminium base 8 and a radiation layer 3 which has been directly deposited on it.

In this figure, it is more clearly shown how the heat generated by the LEDs 2 is transmitted by conduction to the aluminium base 8 and then to the radiation layer 3. The radiation layer 3 dissipates the heat by radiation, without the need of an airflow or an air volume to receive this heat.

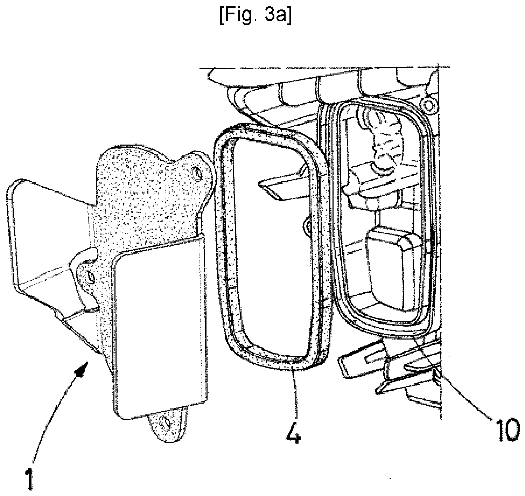

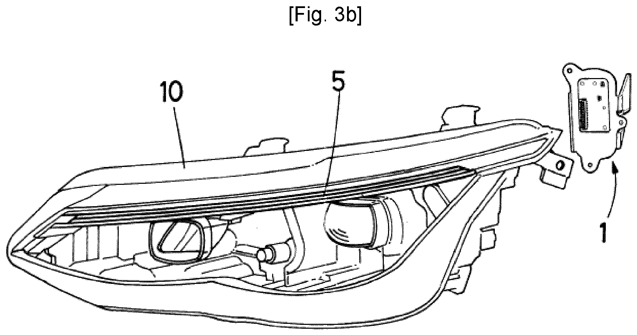

Further, this printed circuit board 1 may act as a cap for a lighting device 10, as seen in Figures 3a and 3b.

A sealing joint 4 is placed in contact with the printed circuit board 1 to create a watertight assembly with the rest of the housing of the lighting device 10. The LEDs 2 of the lighting device 10 are intended to provide a daytime running light functionality. For this aim, a light guide 5 is also provided in the lighting device 10, to receive the light produced by the LEDs 2 and project it as a daytime running light pattern outside the lighting device 10.

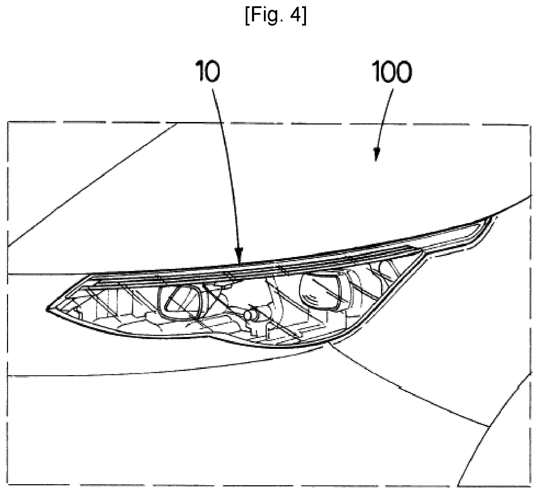

Figure 4 shows an automotive vehicle 100 comprising an automotive lighting device 10 as described in the previous figures.

The assembly of this lighting device 10 may be lighter and smaller than the traditional ones, thus decreasing the volume and weight of the lighting device and offering more design possibilities to the car manufacturer.

## Claims

1. Automotive lighting device (10) comprising
a housing with a hole edge;
a circuit element (1) with a first face (11), a second face (12) opposite to the first face and a side edge (13);
at least a solid-state light source (2) arranged in the first face of the circuit element (1); a heat dissipation element (3) arranged on the second face (12) of the circuit element; wherein the circuit element (1) is a printed circuit board, wherein the first face of the circuit element (1) comprises a copper layer (6) and the at least one solid-state light source (2) is arranged in the copper layer by means of a solder mask (7);
**characterized in that** the second face (12) of the circuit element comprises a metallic base (8) which is attached to the copper layer by means of a dielectric element;
**in that** a sealing element (4) is arranged in contact with the first face (11) of the circuit element (1) and with the hole edge (9) of the housing to provide a seal of the lighting device (10), and
**in that** the heat dissipation element (3) is a radiation layer (3) which has an emissivity higher than 0.5 and more particularly, higher than 0.8.

2. Automotive lighting device (10) according to claim 1, wherein the metallic base (8) comprises aluminium and/or an aluminium alloy.

3. Automotive lighting device (10) according to any of the preceding claims, wherein the radiation layer (3) is directly deposited on the metallic base (8).

4. Automotive lighting device (10) according to any of the preceding claims, wherein the radiation layer comprises resin and/or a polyamide, and/or a ceramic compound and/or talc and/or a paint coating.

5. Automotive lighting device according to claims 1 , wherein the radiation layer (3) is obtained by processing the second face of the circuit element.

6. Automotive lighting device according to claim 5, wherein the process comprises an oxidation, corrosion or anodising of the second face of the circuit element.

7. Automotive lighting device according to any of the preceding claims, wherein the heat dissipation element (3) has a thickness comprised between 0.5 and 2 mm.

8. Automotive lighting device (10) according to any of the preceding claims, wherein the solid-state light source (2) is configured to be part of a daytime running time functionality or a turning indicator functionality.

9. Automotive lighting device (10) according to any of the preceding claims, further comprising an optical element (5) suitable for receiving light emitted by the light source (2) and for shaping the light into a light pattern projected outside the lighting device (10).

## Patentansprüche

1. Kraftfahrzeugbeleuchtungsvorrichtung (10), umfassend
ein Gehäuse mit einer Lochkante;
ein Schaltungselement (1) mit einer ersten Fläche (11), einer zweiten Fläche (12) gegenüber der ersten Fläche und einer Seitenkante (13);
mindestens eine Festkörperlichtquelle (2), die auf der ersten Fläche des Schaltungselements (1) angeordnet ist;
ein Wärmeableitungselement (3), das auf der zweiten Fläche (12) des Schaltungselements angeordnet ist;
wobei das Schaltungselement (1) eine Leiterplatte ist, wobei die erste Fläche des Schaltungselements (1) eine Kupferschicht (6) umfasst und die mindestens eine Festkörperlichtquelle (2) in der Kupferschicht mittels einer Lötmaske (7) angeordnet ist; **dadurch gekennzeichnet, dass** die zweite Fläche (12) des Schaltungselements eine metallische Basis (8) umfasst, die mittels eines dielektrischen Elements an der Kupferschicht befestigt ist;
dass ein Dichtungselement (4) in Kontakt mit der ersten Fläche (11) des Schaltungselements (1) und mit der Lochkante (9) des Gehäuses angeordnet ist, um eine Abdichtung der Beleuchtungsvorrichtung (10) zu gewährleisten, und
dass das Wärmeableitungselement (3) eine Strahlungsschicht (3) ist, die einen Emissionsgrad höher als 0,5 und insbesondere höher als 0,8 aufweist.

2. Kraftfahrzeugbeleuchtungsvorrichtung (10) nach Anspruch 1, wobei die metallische Basis (8) Aluminium und/oder eine Aluminiumlegierung umfasst.

3. Kraftfahrzeugbeleuchtungsvorrichtung (10) nach einem der vorhergehenden Ansprüche, wobei die Strahlungsschicht (3) direkt auf der metallischen Basis (8) abgeschieden ist.

4. Kraftfahrzeugbeleuchtungsvorrichtung (10) nach einem der vorhergehenden Ansprüche, wobei die Strahlungsschicht Harz und/oder ein Polyamid und/oder eine keramische Verbindung und/oder Talk und/oder eine Lackbeschichtung umfasst.

5. Kraftfahrzeugbeleuchtungsvorrichtung nach Anspruch 1, wobei die Strahlungsschicht (3) durch Bearbeitung der zweiten Fläche des Schaltungselements erhalten wird.

6. Kraftfahrzeugbeleuchtungsvorrichtung nach Anspruch 5, wobei der Prozess eine Oxidation, Korrosion oder Anodisierung der zweiten Fläche des Schaltungselements umfasst.

7. Kraftfahrzeugbeleuchtungsvorrichtung nach einem der vorhergehenden Ansprüche, wobei das Wärmeableitungselement (3) eine Dicke zwischen 0,5 und 2 mm aufweist.

8. Kraftfahrzeugbeleuchtungsvorrichtung (10) nach einem der vorhergehenden Ansprüche, wobei die Festkörperlichtquelle (2) konfiguriert ist, Teil einer Tagfahrlichtfunktionalität oder einer Blinkerfunktionalität zu sein.

9. Kraftfahrzeugbeleuchtungsvorrichtung (10) nach einem der vorhergehenden Ansprüche, ferner umfassend ein optisches Element (5), das geeignet ist, von der Lichtquelle (2) emittiertes Licht zu empfangen und das Licht in ein Lichtmuster zu formen, das außerhalb der Beleuchtungsvorrichtung (10) projiziert wird.

## Revendications

1. Dispositif d'éclairage automobile (10) comprenant
un boîtier avec un bord de trou;
un élément de circuit (1) avec une première face (11), une deuxième face (12) opposée à la première face et un bord latéral (13);
au moins une source lumineuse à semi-conducteurs (2) disposée sur la première face de l'élément de circuit (1);
un élément de dissipation thermique (3) disposé sur la deuxième face (12) de l'élément de circuit;
dans lequel l'élément de circuit (1) est une carte de circuit imprimé, dans lequel la première face de l'élément de circuit (1) comprend une couche de cuivre (6) et l'au moins une source lumineuse à semi-conducteurs (2) est disposée dans la couche de cuivre au moyen d'un masque de soudure (7);
**caractérisé en ce que** la deuxième face (12) de l'élément de circuit comprend une base métallique (8) qui est fixée à la couche de cuivre au moyen d'un élément diélectrique;
**en ce qu'**un élément d'étanchéité (4) est disposé en contact avec la première face (11) de l'élément de circuit (1) et avec le bord de trou (9) du boîtier pour assurer l'étanchéité du dispositif d'éclairage (10), et
**en ce que** l'élément de dissipation thermique (3) est une couche de rayonnement (3) qui a une émissivité supérieure à 0,5 et plus particulièrement, supérieure à 0,8.

2. Dispositif d'éclairage automobile (10) selon la revendication 1, dans lequel la base métallique (8) comprend de l'aluminium et/ou un alliage d'aluminium.

3. Dispositif d'éclairage automobile (10) selon l'une quelconque des revendications précédentes, dans lequel la couche de rayonnement (3) est directement déposée sur la base métallique (8).

4. Dispositif d'éclairage automobile (10) selon l'une quelconque des revendications précédentes, dans lequel la couche de rayonnement comprend de la résine et/ou un polyamide, et/ou un composé céramique et/ou du talc et/ou un revêtement de peinture.

5. Dispositif d'éclairage automobile selon la revendication 1, dans lequel la couche de rayonnement (3) est obtenue par traitement de la deuxième face de l'élément de circuit.

6. Dispositif d'éclairage automobile selon la revendication 5, dans lequel le processus comprend une oxydation, une corrosion ou une anodisation de la deuxième face de l'élément de circuit.

7. Dispositif d'éclairage automobile selon l'une quelconque des revendications précédentes, dans lequel l'élément de dissipation thermique (3) a une épaisseur comprise entre 0,5 et 2 mm.

8. Dispositif d'éclairage automobile (10) selon l'une quelconque des revendications précédentes, dans lequel la source lumineuse à semi-conducteurs (2) est configurée pour faire partie d'une fonctionnalité de feux de jour ou d'une fonctionnalité d'indicateur de direction.

9. Dispositif d'éclairage automobile (10) selon l'une quelconque des revendications précédentes, comprenant en outre un élément optique (5) adapté pour recevoir la lumière émise par la source lumineuse (2) et pour façonner la lumière en un motif lumineux projeté à l'extérieur du dispositif d'éclairage (10).
